# EUROPEAN PATENT SPECIFICATION

(11) **EP 1 473 592 B1**
(45) Date of publication and mention of the grant of the patent: **11.02.2009**
(21) Application number: 04009985.5
(22) Date of filing: 27.04.2004
(51) Int. Cl.: G03C 1/73

(54) **Image display medium and image forming method**
Bildanzeigemittel und Bilderzeugungsverfahren
Moyen d' affichage d' image et procédé de formation d' image

(30) Priority: 28.04.2003 JP 2003123723; 24.12.2003 JP 2003426253
(43) Date of publication of application: 03.11.2004
(73) Proprietor: Ricoh Company, Ltd., Tokyo 143-8555 (JP)
(72) Inventor: Takahashi, Hiroyuki, Ohta-ku Tokyo 143-8555 (JP); Hirano, Shigenobu, Ohta-ku Tokyo 143-8555 (JP); Kawashima, Ikue, Ohta-ku Tokyo 143-8555 (JP)
(74) Representative: Barz, Peter

(56) References cited:
- JP-A- 2002 274 043
- US-A- 4 960 679

## Description

### BACKGROUND OF THE INVENTION

### Field of the Invention

The present invention relates to an image display medium and an image forming method. Particularly, the present invention relates to an image display medium which can repeatedly display when being irradiated by light, and a method for forming an image in the image displaying medium.

### Discussion of the Background

Various rewritable image display media which can reversibly form images using a photochromic compound which can reversibly exhibit color change when being irradiated by light have been proposed. However, there is no display medium which can rewrite color images so many times as to be practically used.

Published unexamined Japanese Patent Application No. (hereinafter referred to as JOP) 05-271649 discloses a method for forming a color image using three photochromic diarylethene compounds, i.e., a compound coloring yellow-orange when being exposed to ultraviolet light having a wavelength of 254 nm, a compound coloring red when being exposed to ultraviolet light having a wavelength of 313 nm, and a compound coloring blue-violet when being exposed to ultraviolet light having a wavelength of 365 nm. In the method, one or more of the ultraviolet light beams mentioned above irradiate the compounds to form a color image.

In order to form a full color image, coloring and discoloring of three or more kinds of photochromic compounds which color three primary colors (i.e., blue, green and red, or yellow, magenta and cyan) have to be controlled using light.

In the method mentioned above, each of the three compounds has to be colored by the corresponding ultraviolet light without being colored by the other ultraviolet light. In other words, it is necessary that the light absorption curves of the three compounds do not overlap with each other. In addition, the compounds have to show the above-mentioned three primary colors. However, the compounds disclosed in the publication cannot fulfill these requirements.

In addition, in order that such a display medium is commercialized, the display medium has to have good durability, good resistance to heat and humidity, and the like properties.

JOP 07-199401 discloses a method for forming a color image, which includes the following steps:
(1) ultraviolet light having a wavelength of 366 nm irradiates three photochromic fulgide compounds to color the compounds yellow, magenta and cyan, respectively; and
(2) then white light irradiates the colored three compounds through a color positive film of the image to be produced to selectively discolor one or more of the colored compounds.

This method has an advantage in that only one kind of ultraviolet light is used. However, a color positive film of the image to be produced is necessary, and therefore this method is not practical. This method is not suitable for office use.

Thus, there is no color display medium which can rewrite color images using photochromic compounds and which can be used practically.

Another color image forming method using photochromic compounds is disclosed, which is as follows.
(1) irradiating a photosensitive layer with ultraviolet light such that all of the photochromic compounds in the photosensitive layer color; and
(2) irradiating a predetermined portion of the colored photosensitive layer with visible light having a wavelength corresponding to the wavelength of the maximum absorption of one or more colored photochromic compounds to discolor the portion, to prepare a desired multi-color image.

However, this method has a disadvantage in that it takes a long time in the discoloring process using visible light. Therefore, it is necessary to use photochromic compounds having high discoloring sensitivity. However, since the color images are typically observed in illuminated places, the colored photochromic compounds preferably have a low discoloring sensitivity, i.e., a good color retentivity. Therefore, the problems to be solved, i. e. , to shorten the image forming time and to improve the color retentivity of displayed color images, establish a trade-off relationship. Therefore, a need exists for a technique such that when an image is formed in an image display medium, the discoloring sensitivity of the photochromic compounds is temporarily heightened, and the resultant colored image has a low discoloring sensitivity.

In view of such situation, the present inventors have disclosed a color image forming method and apparatus in JOPs 2003-241339 and 2003-312064, by which high definition multi-color images can be easily formed repeatedly. Specifically, the method and apparatus uses an image display medium in which a photosensitive layer including plural photochromic compounds is provided on a substrate. The photochromic compounds have properties such that the wavelengths at which the colored compounds of the photochromic compounds have maximum absorption are different from the others. In the publications, the present inventors propose some techniques to improve the image forming time and the color retentivity of images.

In the publications the present inventors have disclosed a technique such that interaction of a photochromic compound and an electron accepting compound is changed by heating the compounds to change the discoloring sensitivity of the photochromic compound.

Recently there is an increased demand for high quality color display medium. Namely, a need exists for a photochromic color display medium which can rapidly display a higher quality color image having good color retentivity.

### SUMMARY OF THE INVENTION

Accordingly, an object of the present invention is to provide a rewritable image display medium which can display high-quality/high-definition images in a relatively short time using photochromic compounds and which has good color retentivity.

Another object of the present invention is to provide an image forming method by which high-quality/high-definition images having good color retentivity can be displayed in a relatively short time using photochromic compounds.

Briefly these objects and other objects of the present invention as hereinafter will become more readily apparent can be attained by an image display medium having a substrate and a photosensitive layer which is located overlying the substrate and includes a microcapsule containing at least a photochromic compound and at least an electron accepting compound, wherein the electron accepting compound includes a Lewis acid compound having not less than 12 carbon atoms except for the carbons included in the Lewis acid group.

The photochromic compound preferably includes a fulgide compound.

It is preferable that the photosensitive layer further includes a binder.

In addition, it is preferable that the microcapsule further includes an infrared absorbing dye.

Alternatively, a heat generating layer including an infrared absorbing dye is formed between the substrate and the photosensitive layer or on the photosensitive layer.

It is preferable that the photochromic compound includes two or more kinds of photochromic compounds having different maximum absorption wavelengths, preferably a photochromic compound (A) having a maximum absorption wavelength not less than 400 nm and less than 500 nm, a photochromic compound (B) having a maximum absorption wavelength not less than 500 nm and less than 600 nm, and a photochromic compound (C) having a maximum absorption wavelength not less than 600 nm and less than 700 nm.

The microcapsule preferably includes a first microcapsule containing only the compound (A) as the photochromic compound, a second microcapsule containing the compound (B) as the photochromic compound, and a third microcapsule containing the compound (C) as the photochromic compound.

A protective layer is preferably formed overlying the photosensitive layer (or the heat generating layer) as an outermost layer of the image display medium.

As another aspect of the present invention, an image forming method is provided, which includes the steps of:
irradiating the image display medium mentioned above with ultraviolet light to color the at least one photochromic compound;
heating the image display medium to a temperature not lower than the melting point of the at least one electron accepting compound;
irradiating a predetermined portion of the image display medium with visible light corresponding to the maximum absorption wavelength of the colored photochromic compound to discolor the portion of the colored image display medium (i.e. , to form a color image); and
heating the image display medium to a temperature lower than the melting point of the at least one electron accepting compound.

It is preferable that when the infrared absorbing dye is included in the photosensitive layer or the heat generating layer, the heating is performed by irradiating infrared light.

These and other objects, features and advantages of the present invention will become apparent upon consideration of the following description of the preferred embodiments of the present invention taken in conjunction with the accompanying drawings.

### BRIEF DESCRIPTION OF THE DRAWINGS

FIGS. 1 (A) and 1 (B) are schematic views illustrating how the photosensitive layer of the image display medium of the present invention is discolored by visible lights having different wavelengths;
FIGS. 2 to 5 are schematic views illustrating cross sections of embodiments of the image display medium of the present invention;
FIG. 6 is a schematic view illustrating the relationship between the visible light irradiation time and the reflectance of an embodiment of the image display medium of the present invention; and
Fig. 7 is a schematic view for explaining how the discoloring energy is defined.

### DETAILED DESCRIPTION OF THE INVENTION

Generally, the image display medium of the present invention has a photosensitive layer including a microcapsule containing at least one photochromic compound, and at least one electron accepting compound including a Lewis acid. By properly heating the image display medium, the discoloring sensitivity thereof can be changed (i.e., increased and decreased).

At first, the image display medium of the present invention and the method for forming a color image therein will be explained.

An embodiment of the image display medium of the present invention, which has a substrate and a photosensitive layer located overlying the substrate and including two or more kinds of photochromic compounds having different maximum absorption wavelengths, will be explained referring to drawings.

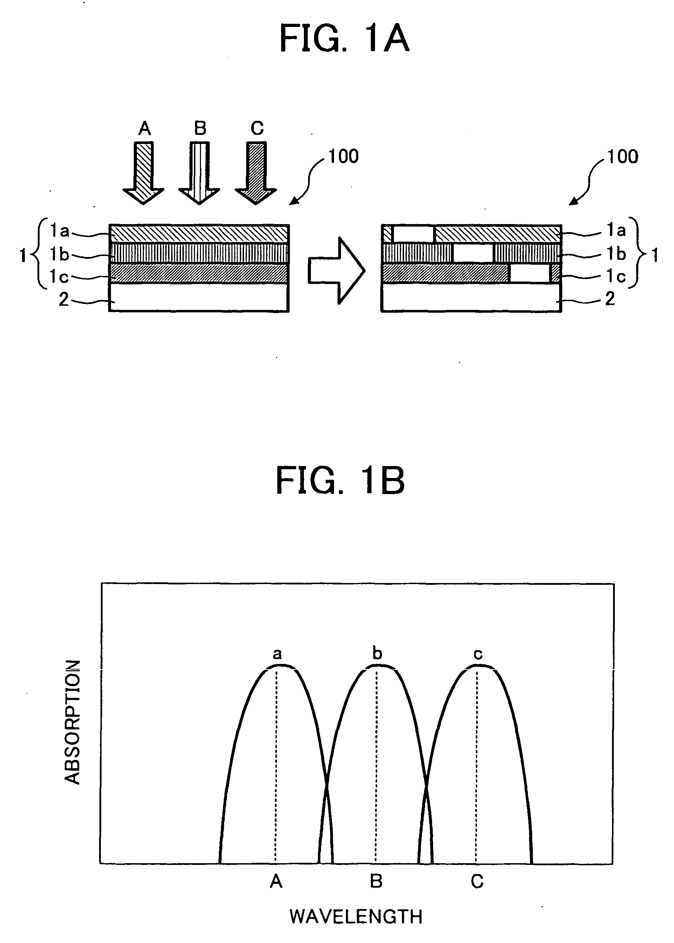

Referring to FIG. 1(A), a photosensitive layer 1 which is formed on a substrate 2 and which includes a first photosensitive layer 1a including a first photochromic compound (a), a second photosensitive layer 1b including a second photochromic compound (b) , and a third photosensitive layer 1c including a third photochromic compound (c).

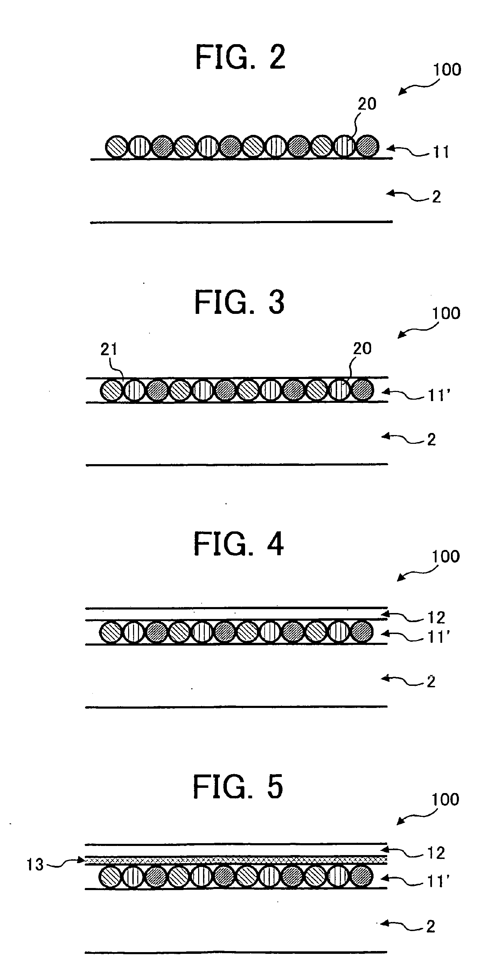

FIGS. 2 to 5 are schematic views illustrating other embodiments of the image display medium of the present invention.

Referring to FIG. 2, an image displaying medium 100 includes a photosensitive layer 11 which is located on a substrate 2 and includes a microcapsule 20 including at least one or more photochromic compounds and one or more electron accepting compounds.

Referring to FIG. 3, the image displaying medium 100 includes a photosensitive layer 11' which is located on the substrate 2 and includes the microcapsule 20 including at least one or more photochromic compounds and one or more electron accepting compounds and a binder 21.

Referring to FIG. 4, the image display medium 100 include the photosensitive layer 11' located on the substrate 2, and a protective layer 12 located on the photosensitive layer 11'.

Referring to FIG. 5, the image display medium 100 include the photosensitive layer 11' located on the substrate 2, a heat generating layer 13 which is located on the photosensitive layer 11' and includes a heat generating material such as infrared absorbing dye, and the protective layer 12 located on the heat generating layer 13.

Then the method for displaying a color image in the image display medium will be explained referring to FIGS. 1(A) and 1(B) :
(1) irradiating the image display medium with ultraviolet light to color all the photochromic compounds (a), (b) and (c) in the photosensitive layer 1; and
(2) imagewise irradiating the colored display medium with plural kinds of lights (A, B and C illustrated in FIG. 1(A)) having different wavelengths corresponding to or near the maximum absorption wavelengths of the colored photochromic compounds (a), (b) and (c) to discolor a predetermined portion of the colored photosensitive layer (i. e. , to form a color image).

Then coloring of the photosensitive layer will be explained in detail.

The colored photosensitive layers 1a, 1b and 1c (i.e., the colored photochromic compounds (a), (b) and (c)) have different maximum absorption wavelengths. This means that the photosensitive layers have different colors. The maximum absorption wavelengths of the colored photosensitive layers are determined depending on the colors of the image to be shown by the image display medium. Namely, photochromic compounds, each of which has one of the maximum absorption wavelengths in the colored state, are used for the photosensitive layers.

It is preferable to use a photochromic compound having a maximum absorption wavelength not less than 400 nm and less than 500 nm in the colored state, a photochromic compound having a maximum absorption wavelength not less than 500 nm and less than 600 nm in the colored state, and a photochromic compound having a maximum absorption wavelength not less than 600 nm and less than 700 nm in the colored state, for the photosensitive layers 1a, 1b and 1c, respectively. In this case, the colors of the colored photosensitive layers 1a, 1b and 1c are three primary colors, i.e., yellow, magenta and cyan.

In addition, by controlling the degree of discoloring of the photosensitive layers by controlling the energy of visible light used for discoloring, the color density of the image can be controlled. Therefore, the image display medium of the present invention can show various colors, i. e. , the medium has wide color reproducibility.

Hereinbefore, the photosensitive layer including two or more photochromic compounds are explained. However, a photosensitive layer including only one kind of photochromic compound can also be used. In this case, the resultant image display medium shows monochrome images which have the same color tone and different image densities. However, the image forming method is basically the same as that mentioned above.

Suitable photochromic compounds for use in the photosensitive layer of the image display medium of the present invention include heat irreversible photochromic compounds such as fulgide compounds and diaryl ethene compounds, and heat reversible photochromic compounds such as spiropyran compounds and spirooxazine compounds. In the present invention, it is preferable to use the heat irreversible photochromic compounds.

The photosensitive layer can include a binder. Suitable materials for use as the binder include resins which can be mixed with the photochromic compounds used without adversely affecting the photochromic compounds and which have good film formability and transparency even after the resins are crosslinked. Specific examples of the resins include polystyrene, polyester, polymethyl methacrylate, vinyl chloride / vinyl acetate copolymers, polyvinyl chloride, polyvinylidene chloride, polyvinyl acetate, etc.

Suitable materials for use in the substrate include transparent materials such as polyethylene terephthalate, polyethersulfone and polycarbonate, and opaque materials such as papers.

Suitable methods for use in forming the photosensitive layer include coating methods and deposition methods. Among these methods, the coating methods are preferable because of being simple. The photosensitive layer is typically prepared by the following coating method:
(1) coating a coating liquid, which is prepared by mixing a microcapsule in which one or more photochromic compounds and one or more electron accepting compounds are dissolved in a solvent with a binder solution, by a method such as printing methods and spin coating methods; and
(2) drying the coated liquid to form a film.

The photosensitive layer may be a single layer including all photochromic compounds which color differently or may be constituted of plural layers, each of which includes one (or more) of the photochromic compounds such that the plural layers color differently.

In the present invention, the discoloring sensitivity of the image display medium is controlled in order that the image forming time is shortened and the resultant images have good color retentivity. Then the method for controlling the discoloring sensitivity will be explained in detail.

The image display medium of the present invention has a substrate and a photosensitive layer which is located overlying the substrate and includes a microcapsule containing at least one photochromic compound and at least one electron accepting compound, wherein the electron accepting compound includes a Lewis acid having not less than 12 carbon atoms except for the carbons included in the Lewis acid group. The photochromic compound is preferably a fulgide compound.

As another aspect of the present invention, an image forming method is provided. The method includes the following steps:
(1) irradiating the image display medium mentioned above with ultraviolet light to color the at least one photochromic compound;
(2) heating the image display medium to a temperature not lower than the melting point of the at least one electron accepting compound;
(3) irradiating a predetermined portion of the image display medium with visible light corresponding to the maximum absorption wavelength of the colored photochromic compound to discolor the portion of the colored image display medium (i.e., to form a color image); and
(4) heating the image display medium to a temperature lower than the melting point of the electron accepting compound.

By using the image display medium and the image forming method, the discoloring sensitivity can be controlled (i.e., increased and decreased) . Specifically, it is preferable that when an image is formed, the discoloring sensitivity of the photochromic compound is temporarily increased, and after the image forming process, the discoloring sensitivity of the image display medium is decreased.

The reason why the discoloring sensitivity can be controlled is considered to be as follows. The discoloring sensitivity of a photochromic compound directly depends on the discolor reaction quantum efficiency (φ CE). Therefore, change of the quantum efficiency (φ CE) will be discussed hereinafter to explain the discoloring sensitivity.

Fulgide compounds for use as the photochromic compound for use in the image display medium of the present invention have one of the following formulae (1) and (2).

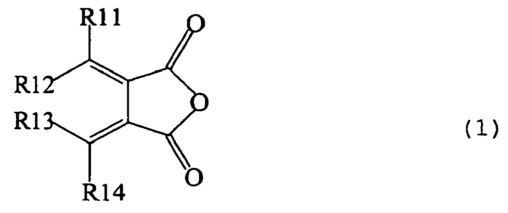

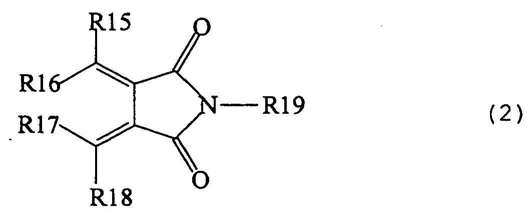

The discoloring sensitivity of fulgide compounds depends on the structure (i.e., whether the compounds have formula (1) or (2)), and the electronic properties of the aromatic ring moiety of the compounds (i.e., whether the moiety has an electron donating property or an electron accepting property). Specifically, when the aromatic ring moiety has an electron donating property, the fulgide compounds have low discoloring sensitivity. In contrast, when the aromatic ring moiety has an electron accepting property, the fulgide compounds have high discoloring sensitivity.

In addition, the discoloring sensitivity of a photochromic compound also depends on the electronic property of the material surrounding the molecules of the photochromic compound. Namely, the electronic property of the aromatic ring moiety of a fulgide compound is changed by the interaction between the material and the aromatic ring moiety. For example, when the interaction of the electron accepting moiety of the material and the aromatic ring moiety of the fulgide compound increases, the electron donating property of the aromatic ring moiety is weakened, and thereby the discoloring sensitivity of the fulgide compound is increased. In contrast, when the interaction decreases, the electron donating property of the aromatic ring moiety is strengthened, and thereby the discoloring sensitivity of the fulgide compound is decreased. Thus, by controlling the interaction, the discoloring sensitivity can be controlled.

Diarylethene compounds for use as the photochromic compound for use in the image display medium of the present invention have the following formula (3).

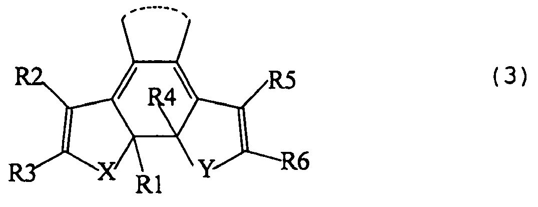

The discoloring sensitivity of diarylethene compounds depends on the structure, and the electronic properties of the moiety including the 5-member ring including the groups R2 and R3, and the moiety including the other 5-member ring including the groups R5 and R6. Specifically, when the moieties have an electron donating property, the diarylethene compounds have low discoloring sensitivity. In contrast, when the moieties have an electron accepting property, the diarylethene compounds have high discoloring sensitivity.

In addition, the electronic property of the moieties of a diarylethene compound is changed by the interaction between the material surrounding the compound and the moieties of the compound. For example, when the interaction of the electron accepting moiety of the material and the moieties of the diaryethene compound increases, the electron donating property of the moieties is weakened, and thereby the discoloring sensitivity of the diaryethene compound is increased. In contrast, when the interaction decreases, the electron donating property of the moieties is strengthened, and thereby the discoloring sensitivity of the diaryethene compound is decreased. Thus, by controlling the interaction, the discoloring sensitivity can be controlled.

By performing the processes mentioned above in the image forming method on the image display medium, the discoloring sensitivity of the medium can be controlled.

The mechanism of controlling discoloring sensitivity will be explained referring to an example of the photosensitive layer including a fulgide compound.

The fulgide compound included in the photosensitive layer of the image display medium colors by being exposed to ultraviolet light. When the thus colored photosensitive layer is temporarily heated to a temperature (I) not lower than the melting point of the electron accepting compound included in the photosensitive layer, the electron accepting compound achieves a state in which molecules of the compound are regularly aggregated to some extent, and thereby the photosensitive layer achieves a stable state in which the acid group of the electron accepting compound closely interacts with the aromatic ring moiety of the fulgide compound. Hereinafter, this stable state is referred to as a state (A) . In this state (A), the photosensitive layer has a high discoloring sensitivity.

By irradiating the photosensitive layer in the state (A) with visible light, the photosensitive layer can be discolored in a short time (i.e., with a small energy). When the photosensitive layer is then heated to a temperature (II) not higher than the melting point of the electron accepting compound (or when the photosensitive layer is heated to a temperature (I) followed by gradual cooling), the acid groups of the electron accepting compound aggregate, and thereby the photosensitive layer achieves a stable state (B) in which the interaction between the aromatic ring moiety of the fulgide compound and the acid group of the electron accepting group is decreased. The photosensitive layer in this state (B) has a low discoloring sensitivity, and therefore the photosensitive layer hardly discolors even when being exposed to light of lamps or the like. Namely, the displayed image has good color retentivity.

In the process in which the photosensitive layer is heated to the temperature (I) so as to achieve the state (A), the temperature (I) is preferably not lower than the melting point of the fulgide compound if the melting point of the fulgide compound is higher than that of the electron accepting compound. It is preferable that the photosensitive layer is rapidly cooled after being heated to the temperature (I). When gradually cooled, the photosensitive layer tends to achieve the state (B) . This is because the temperature range in which the photosensitive layer achieves the state (B) is located below the temperature range in which the photosensitive layer achieves the state (A). Therefore, when the photosensitive layer in the state (A) is heated to the temperature (II), the photosensitive layer achieves the state (B).

The temperatures (I) and (II) are properly determined depending on the species and properties (such as melting point) of the fulgide compound and electron accepting compound used.

Suitable fulgide compounds for use as the photochromic compound include compounds having the following formula (1) or (2), and photochromic compounds having formula (1) or (2) in their structure. 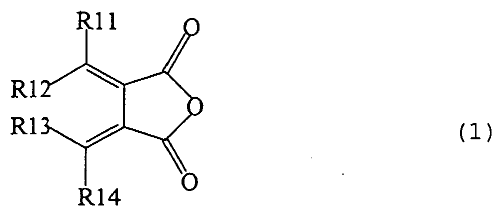 wherein R11, R12, R13 and R14 independently represent a hydrogen atom, an alkyl group, an alkoxy group, an aromatic ring group, and a heterocyclic group, wherein at least one of R11, R12, R13 and R14 is an aromatic ring group or a heterocyclic group. 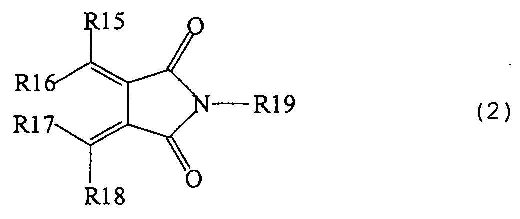 wherein R15, R16, R17, R18 and R19 independently represent a hydrogen atom, an alkyl group, an alkoxy group, an aromatic ring group, and a heterocyclic group, wherein at least one of R15, R16, R17 and R18 is an aromatic ring group or a heterocyclic group.

Suitable diarylethene compounds for use as the photochromic compound include compounds having the following formula (3) and photochromic compounds having formula (3) in their structure. 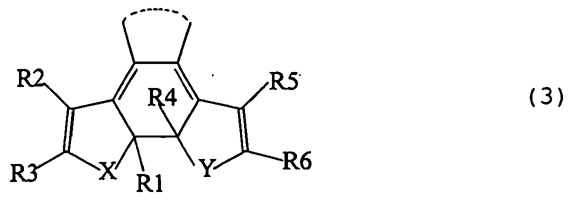 wherein R1, R2, R3, R4, R5 and R6 independently represent a hydrogen atom, an alkyl group, an alkoxy group, an aromatic ring group, and a heterocyclic group; and X and Y independently represent an oxygen atom, a sulfur atom, and a nitrogen atom connected with a hydrogen atom, an alkyl group, an alkoxy group, an aromatic ring group or a heterocyclic group.

Suitable compounds for use as the electron accepting compound include compounds having both a moiety (i.e. , a Lewis acid group) which can change the electronic property of the photochromic compound used (i.e., the photochromic compound in this case) while interacting with the aromatic ring moiety of the photochromic compound and a long chain group such as aliphatic groups which have not less than 12 carbon atoms and which can control the cohesion of the molecules of the electron accepting compounds.

Specific examples of such aliphatic groups include linear or branched alkyl groups and alkenyl groups which can have a substituent such as halogen atoms, alkoxy groups and ester groups.

Specific examples of the Lewis acid group include phosphonic acid groups, carboxylic acid groups and phenolic groups.

Specific examples of the electron accepting compounds include the following compounds.

### Phosphonic acid compounds having the following formula (4)

R1-PO(OH)₂ (4)

wherein R1 represents a group having not less than 12 carbon atoms, such as aliphatic groups.

Specific examples of the phosphonic acid compounds having formula (4) include dodecylphosphonic acid, dococylphosphonic acid, hexadecylphosphonic acid, octadecylphosphonic acid, eicocylphosphonic acid, tetracocylphosphonic acid, hexacocylphosphonic acid, octacocylphosphonic acid, etc.

### Aliphatic carboxylic acid compounds having the following formula (5)

R2-CH(OH)-COOH (5)

wherein R2 represents a group having not less than 12 carbon atoms, such as aliphatic groups.

Specific examples of the aliphatic carboxylic acid compounds having formula (5) include α-hydroxydodecanoic acid, α-hydroxytetradecanoic acid, α-hydroxyhexadecanoic acid, α - hydroxyoctadecanoic acid, α-hydroxypentadecanoic acid, α-hydroxyeicosanoic acid, α-hydroxydocosanoic acid, α-hydroxytetracosanoic acid, α-hydroxyhexacosanoic acid, α-hydroxyoctacosanoic acid, etc.

### Aliphatic carboxylic acid compounds in which at least one of α- and β-position carbon atoms is connected with a halogen atom

Specific examples of such compounds include 2-bromohexadecanoic acid, 2-bromoheptadecanoic acid, 2-bromooctadecanoic acid, 2-bromoeicosanoic acid, 2-bromodocosanoic acid, 2-bromotetracosanoic acid, 3-bromooctadecanoic acid, 3-bromoeicosanoic acid, 2,3-dibromooctadecanoic acid, 2-fluorododecanoic acid, 2-fluorotetradecanoic acid, 2-fluorohexadecanoic acid, 2-fluorooctadecanoic acid, 2-fluoroeicosanoic acid, 2-fluorodocosanoic acid, 2-iodohexadecanoic acid, 2-iodooctadecanoic acid, 3-iodohexadecanoic acid, 3-iodooctadecanoic acid, perfluorooctadecanoic acid, etc.

### Aliphatic carboxylic acid compounds in which at least one of α -, β - and γ -position carbons atom is connected with an oxygen atom

Specific examples of the compounds include 2-oxododecanoic acid, 2-oxotetradecanoic acid, 2-oxohexadecanoic acid, 2-oxooctadecanoic acid, 2-oxoeicosanoic acid, 2-oxotetracosanoic acid, 3-oxododecanoic acid, 3-oxotetradecanoic acid, 3-oxohexadecanoic acid, 3-oxooctadecanoic acid, 3-oxoeicosanoic acid, 3-oxotetracosanoic acid, 4-oxohexadecanoic acid, 4-oxooctadecanoic acid, 4-oxodocosanoic acid, etc.

### Aliphatic dibasic carboxylic acid compounds having the following formula (6)

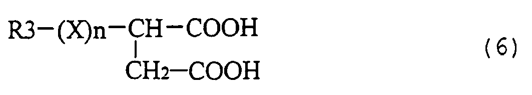

wherein R3 represents a group having not less than 12 carbon atoms, such as aliphatic groups; X represents an oxygen atom or a sulfur atom; and n is 1 when X is an oxygen atom, and n is 1 or 2 when X is a sulfur atom.

Specific examples of the dibasic acids having formula (6) include 2-dodecyloxysuccinic acid, 2-tetradecyloxysuccinic acid, 2-hexadecyloxysuccinic acid, 2-octadecyloxysuccinic acid, 2-eicocyloxysuccinic acid, 2-dococyloxysuccinic acid, 2-tetracocyloxysuccinic acid, 2-dodecylthiosuccinic acid, 2-tetradecylthiosuccinic acid, 2-hexadecylthiosuccinic acid, 2-octadecylthiosuccinic acid, 2-eicocylthiosuccinic acid, 2-dococylthiosuccinic acid, 2-tetracocylthiosuccinic acid, 2-dodecyldithiosuccinic acid, 2-tetradecyldithiosuccinic acid, 2-hexadecyldithiosuccinic acid, 2-octadecyldithiosuccinic acid, 2-eicocyldithiosuccinic acid, 2-dococyldithiosuccinic acid, 2-tetracocyldithiosuccinic acid, etc.

### Aliphatic dibasic carboxylic acid compounds having the following formula (7)

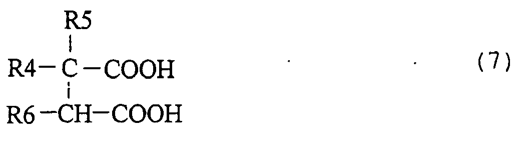

wherein R4, R5 and R6 independently represent a hydrogen atom or an aliphatic group, wherein at least one of R4, R5 and R6 is a group having not less than 12 carbon atoms, such as aliphatic groups.

Specific examples of the dibasic acids having formula (7) include dodecylsuccinic acid, tridecylsuccinic acid, tetradecylsuccinic acid, pentadecylsuccinic acid, octadecylsuccinic acid, eicocylsuccinic acid, dococylsuccinic acid, 2,3-dihexadecylsuccinic acid, 2,3-dioctadecylsuccinic acid, 2-methyl-3-dodecylsuccinic acid, 2-methyl-3-tetradecylsuccinic acid, 2-methyl-3-hexadecylsuccinic acid, 2-ethyl-3-dodecylsuccinic acid, 2-propyl-3-dodecylsuccinic acid, 2-octyl-3-hexadecylsuccinic acid, 2-tetradecyl-3-octadecylsuccinic acid, etc.

### Aliphatic dibasic carboxylic acid compounds having the following formula (8)

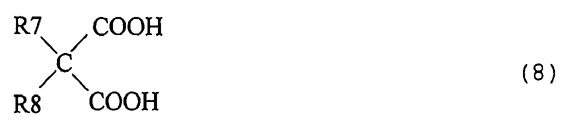

wherein R7 and R8 independently represent a hydrogen atom or an aliphatic group, wherein at least one of R7 and R8 is a group having not less than 12 carbon atoms, such as aliphatic groups.

Specific examples of the dibasic acids having formula (8) include dodecylmalonic acid, tetradecylmalonic acid, hexadecylmalonic acid, octadecylmalonic acid, eicocylmalonic acid, dococylmalonic acid, tetracocylmalonic acid, didodecylmalonic acid, ditetradecylmalonic acid, dihexadecylmalonic acid, dioctadecylmalonic acid, dieicocylmalonic acid, didococylmalonic acid, methyloctadecylmalonic acid, methyleicocylmalonic acid, methyldococylmalonic acid, methyltetracocylmalonic acid, ethyloctadecylmalonic acid, ethyleicocylmalonic acid, ethyldococylmalonic acid, ethyltetracocylmalonic acid, etc.

### Aliphatic dibasic carboxylic acid compounds having the following formula (9)

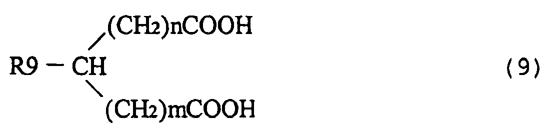

wherein R9 represents a group having not less than 12 carbon atoms, such as aliphatic groups; n is 0 or 1, and m is 1, 2 or 3, wherein n is 0, m is 2 or 3, and when n is 1, m is 1 or 2.

Specific examples of the dibasic acids having formula (9) include 2-dodecylglutaric acid, 2-hexadecylglutaric acid, 2-octadecylglutaric acid, 2-eicocylglutaric acid, 2-dococylglutaric acid, 2-dodecyladipic acid, 2-pentadecyladipic acid, 2-octadecyladipic acid, 2-eicocyladipic acid, 2-dococyladipic acid, etc.

### Phenolic compounds having the following formula (10)

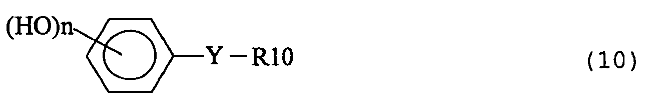

wherein Y represents -S-, -O-, -CONH- or -COO-, R10 represents a group having not less than 12 carbon atoms, such as aliphatic groups; and n is 1, 2 or 3.

Specific examples of the phenolic compounds having formula (10) include p-dodecylthio phenol, p-tetradecylthio phenol, p-hexadecylthio phenol, p-octadecylthio phenol, p-eicocylthio phenol, p-dococylthio phenol, p-tetracocylthio phenol, p-dodecyloxy phenol, p-tetradecyloxy phenol, p-hexadecyloxy phenol, p-octadecyloxy phenol, p-eicocyloxy phenol, p-dococyloxy phenol, p-tetracocyloxy phenol, p-dodecylcarbamoyl phenol, p-tetradecylcarbamoyl phenol, p-hexadecylcarbamoyl phenol, p-octadecylcarbamoyl phenol, p-eicocylcarbamoyl phenol, p-dococylcarbamoyl phenol, p-tetracocylcarbamoyl phenol, hexadecy gallate, octadecyl gallate, eicocyl gallate, dococyl gallate, tetracocyl gallate, etc.

The photochromic compounds and the electron accepting compounds are microencapsulated. Micorocapsules can be prepared by any known methods such as interfacial polymerization methods, in-situ polymerization methods and coacervation methods. For example, the procedure for preparation of microcapsules is as follows, but is not limited thereto.
(1) a mixture of a photochromic compound and an electron accepting compound, which are melted or dissolved in a solvent is added to a solvent, such as water and organic solvents, which optionally includes an additive such as a surfactant, a protective colloid, a pH controlling agent and an electrolyte;
(2) dispersing or emulsifying the mixture in the solvent by performing agitation at a high speed such that the mixture has a desired particle diameter; and
(3) forming a shell on the surface of the particles of the dispersion or emulsion using the methods mentioned above.

Specific examples of the materials for use as the shell of the microcapsule include polymers such as polyurea, polyamide, polyester, polyurethane, epoxy resins, urea resins, melamine resins, gelatin, ethyl cellulose, polystyrene and polyvinyl acetate.

In addition, the thus prepared shell of the microcapsule can be further treated with a material such as melamine resins, urea resins, epoxy resins, aldehyde compounds and isocyanate compounds to be crosslinked. By being crosslinked, the shell can be strengthened, and has an improved heat resistance. Furthermore, the surface of the shell can be covered with a hydrophilic polymer such as gum arabic, gelatin, polyvinyl pyrrolidone, polyvinyl alcohol, carboxymethyl cellulose, methyl cellulose, ethyl cellulose, sodium polyacrylate, polyacrylamide, styrene / maleic anhydride copolymers and ethylene / maleic anhydride copolymers. By being subjected to such a treatment, the shell can be further strengthened.

The particle diameter of the microcapsule is preferably from 0.1 µm to 50 µm.

The contents of the photochromic compound and the electron accepting compound in the microcapsule, which changes depending on the species of the compounds and the combinations of the photochromic compound and the electron accepting compound used, are preferably from 5 to 30 mass %, and from 20 to 80 mass %, respectively.

By microencapsulating a photochromic compound and an electron accepting compound, it becomes possible to prevent the materials other than the compounds from influencing on the interaction between the compounds, i.e., it becomes possible to securely control the interaction therebetween. Therefore, it becomes possible to control (i.e., increase and decrease) the discoloring sensitivity of the resultant image display medium.

Suitable materials for use as the substrate include transparent materials such as polyethylene terephthalate, polyether sulfone and polycarbonate, which can be colored with a colorant; and opaque materials such as papers.

The thus prepared microcapsule is then subjected to a treatment in which water or the organic solvent is removed. In addition, the microcapsule can be heated or placed under a reduced pressure condition to remove the solvent in the microcapsule, if desired. Then the microcapsule is dispersed in a dispersion medium to prepare a photosensitive layer coating liquid. The coating liquid is coated on a substrate by a method such as printing methods, spin coating methods and blade coating methods to prepare a photosensitive layer.

Suitable light sources for use in irradiating the photosensitive layer with ultraviolet light include mercury lamps and xenon lamps, which can be used together with an optical filter to obtain ultraviolet light having a desired wavelength; and light emitting devices such as LEDs and LDs, which can emit light with a specific wavelength.

Suitable light sources for use in irradiating the photosensitive layer with visible light include white light sources, which can be used together with an optical filter to obtain visible light having a desired wavelength; and light emitting devices such as LEDs and LDs, which can emit light with a specific wavelength.

When irradiating only a predetermined portion of the photosensitive layer, a method using a light source array in which light emitting elements capable of emitting light with a specific wavelength are continuously arranged; a method in which one or both of a light source array and the image display medium are moved relative to each other while putting on/off each of the light emitting elements, or the like method can be used.

Suitable devices for use as the heating device for heating the image display medium include any known heaters such as heat rollers, thermal heads, halogen heaters, ceramic heaters and quartz heaters.

By controlling the heating temperature of the heater used, the distance between the heater and the image display medium, the contact pressure and the contact time, or the like factors, the heating conditions for the photosensitive layer, such as heating temperature and heating time, can be adjusted.

The photosensitive layer preferably includes the microcapsule and a binder. Suitable materials for use as the binder include resins having good film forming property and good transparency, such as polystyrene, polyester, polycarbonate, polymethyl methacrylate, vinylchloride / vinylidene chloride copolymers, polyvinyl chloride, polyvinylidene chloride, polyvinyl acetate, phenoxy resins, aromatic polyesters, phenolic resins, epoxy resins, etc.

By coating a coating liquid in which the microcapsule is dispersed in a liquid in which a binder is dissolved in a solvent, on a substrate using the coating method as mentioned above, followed by drying, the image display medium can be prepared. In this case, the adhesion of the microcapsule particles to each other and to the substrate can be improved, and therefore the resultant photosensitive layer and image display medium have good physical strength.

In the present invention, it is preferable to include an infrared absorbing dye in the microcapsule and to irradiate the photosensitive layer with infrared light, in order that the infrared absorbing dye absorbs the infrared light and generates heat. This heating operation is useful for the heating process in which the electron accepting compound is heated to a temperature (I) not lower than the melting point thereof such that the photosensitive layer achieves the state (A), and the heating process in which the electron accepting compound is heated to a temperature (II) lower than the melting point thereof such that the photosensitive layer achieves the state (B) . When an infrared absorbing dye, which generates heat when exposed to infrared light, is included in the microcapsule together with the photochromic compound and the electron accepting compound, the compounds can be effectively heated.

Suitable infrared absorbing dyes include naphthalocyanine dyes, cyanine dyes, metal complex dyes, etc.

When a photochromic compound, an electron accepting compound and an infrared absorbing dye are included in the photosensitive layer, the contents of the photochromic compound, the electron accepting compound and the infrared absorbing dye in the layer are generally from 5 to 30 mass %, from 20 to 80 mass %, and from 5 to 30 mass %.

Suitable light sources for use in irradiating the photosensitive layer with infrared light include infrared light sources, which can be used together with an optical filter to cut unnecessary light; and light emitting devices such as LEDs and LDs, which can emit light with a specific wavelength.

When irradiating the entire photosensitive layer, a large size light source; and a light source array in which light emitting elements capable of emitting infrared light are continuously arranged; and a device using an optical system to adjust the light flux having a proper size, can be used. When irradiating a small portion with infrared light, a device using an optical system to adjust the light flux having a proper size can be preferably used. In the heating process, the temperature of the heated photosensitive layer can be controlled by adjusting the strength of the irradiation light and the irradiation time.

Alternatively, the photosensitive layer can include a microcapsule containing at least a photochromic compound and an electron accepting compound; a binder resin; and an infrared absorbing dye. Such a photosensitive layer can be prepared by coating a coating liquid in which a microcapsule is dispersed in a solution including a binder and an infrared absorbing dye, on a substrate, followed by drying. In this case, the infrared absorbing dye is included in the photosensitive layer, the microcapsule can be easily prepared (i.e., the flexibility in forming the microcapsule can be improved).

The weight ratio (M/B) of the microcapsule (M) to the binder (B) in the photosensitive layer is preferably from 10/1 to 1/100.

By irradiating such a photosensitive layer with infrared light, the photosensitive layer can be heated. Thus, the heating operations mentioned above can be easily carried out.

Alternatively, a heat generating layer which includes an infrared absorbing dye and which generates heat when being irradiated by infrared light may be formed between the substrate and the photosensitive layer, or on the photosensitive layer. In this case, any one of the photosensitive layers mentioned above can be used as the photosensitive layer. The heat generating layer can be prepared by, for example, a coating method in which a coating liquid including an infrared absorbing dye is dissolved in a binder solution is coated by any one of the known coating methods mentioned above.

By irradiating a combination of the photosensitive layer and the heat generating layer with infrared light, the photosensitive layer can be heated. Thus, the heating operations mentioned above can be easily carried out.

It is preferable for the image display medium of the present invention to include two or more kinds of photochromic compounds which have different maximum absorption wavelengths when achieving a colored state. In this case, the image display medium can display multi-color images.

The method for forming a multi-color image in the image display medium includes the following processes:
(1) a process in which at least ultraviolet light irradiates all the photochromic compounds included in the photosensitive layer to color the compounds;
(2) a process in which the photosensitive layer is heated to heat one or more electron accepting compounds included therein to a temperature not lower than the melting point of the electron accepting compounds;
(3) a process in which visible lights having wavelengths corresponding to the maximum absorption wavelengths of the respective colored photochromic compounds irradiate predetermined portions of the colored photosensitive layer to discolor the corresponding colored photochromic compounds in the predetermined portions; and
(4) a process in which the photosensitive layer is heated to heat the electron accepting compounds to a temperature lower than the melting point of the electron accepting compounds to decrease the discoloring sensitivity of the colored photochromic compounds.

In the heating processes, the heating method mentioned above using an infrared absorbing dye can be preferably used.

When colored photochromic compounds have different maximum absorption wavelengths, the colored photochromic compounds have different colors. Namely, two or more of proper photochromic compounds are selected such that the desired color images can be displayed by the photochromic compounds.

It is preferable for the photosensitive layer to include a first photochromic compound (A) having a maximum absorption wavelength not less than 400 nm and less than 500 nm when achieving a colored state, a second photochromic compound (B) having a maximum absorption wavelength not less than 500 nm and less than 600 nm when achieving a colored state, and a third photochromic compound (C) having a maximum absorption wavelength not less than 600 nm and less than 700 nm.

In this case, the photochromic compounds (A) , (B) and (C) show yellow, magenta and cyan colors, respectively, and thereby a full color image can be displayed.

In addition, by controlling the degree of the visible light irradiation for discoloring, the density of the color image can be adjusted. Therefore, the image display medium can show a large variety of colors.

When plural kinds of visible lights irradiate the same portion of the photosensitive layer to discolor plural colored photochromic compounds, the visible lights can irradiate the photosensitive layer at the same time or one by one. In the latter case, the order of irradiation of the plural lights is not particularly limited.

Specific examples of the fulgide compounds having a maximum absorption wavelength not less than 400 nm and less than 500 nm when achieving a colored state include 2-[1-(5-methyl-2-p-dimethylaminophenyl-4-oxazolyl)-2-trifluoromethylethylidene]-3-isopropylidene succinic anhydride, 2-[1-(5-methyl-3-p-dimethylaminophenyl-4-isooxazolyl)-2-trifluoromethylethylidene]-3-isopropylidene succinic anhydride, 2-[1-(5-methyl-2-p-dimethylaminophenyl-4-thiazolyl)-2-trifluoromethylethylidene]-3-isopropylidene succinic anhydride, etc.

Specific examples of the fulgide compounds having a maximum absorption wavelength not less than 500 nm and less than 600 nm when achieving a colored state include 2-[1-(5-methyl-2-p-dimethylaminophenyl-4-oxazolyl)ethylidene]-3-isopropylidene succinic anhydride, 2-[1-(5-methyl-2-p-dimethylaminophenyl-4-thiazolyl)ethylidene]-3-isopropylidene succinic anhydride, 2-[1-(5-methyl-2-p-dimethylaminostyryl-4-oxazolyl)ethylidene]-3-isopropylidene succinic anhydride, 2-[1-(5-methyl-4-p-dimethylaminophenyl)butadiene-1-yl)-4-[oxazolyl]ethylidene]-3-isopropylidene succinic anhydride, etc.

Specific examples of the fulgide compounds having a maximum absorption wavelength not less than 600 nm and less than 700 nm when achieving a colored state include 2-[1-(2,5-dimethyl-1-p-dimethylaminophenyl-3-pyrrolyl)ethylidene]-3-isopropylidene succinic anhydride, 2-[1-(5-methyl-2-p-dimethylaminophenyl-1-phenyl-3-pyrrolyl)ethylidene]-3-isopropylidene succinic anhydride, 2-[1-(1,2-dimethyl-5-dimethylamino-3-indolyl)ethylidene]-3-isopropylidene succinic anhydride, 2-[2,6-dimethyl-3,5-bis(p-dimethylaminostyryl)benzylidenel-3-isopropylidene succinic anhydride, etc.

Such photochromic compounds (A), (B) and (C) as having different maximum absorption wavelengths are preferably contained in different microcapsule particles.

When plural photochromic compounds are used, the discoloring photosensitivities of the photochromic compounds are typically different from each other because the interactions between the photochromic compounds and the electron accepting compound used are typically different (i.e. , because the electronic properties of the photochromic compounds are typically different from each other). Therefore, when plural photochromic compounds are contained in one microcapsule together with an electron accepting compound, the degrees of change in discolor-photosensitivity of the colored photochromic compounds are different.

In order that the colored photochromic compounds have almost the same discolor-photosensitivity changing property, or the colored photochromic compounds have the respective predetermined discolor-photosensitivity changing property, it is preferable that each of the photochromic compounds is separately contained in each microcapsule together with a proper electron accepting compound. The plural microcapsules can be included in only one photosensitive layer, or in respective photosensitive layers constituting the photosensitive layer.

In order to determine a proper combination of a fulgide compound with an electron accepting compound, the electron accepting property of the aromatic ring moiety of the fulgide compound and the electron accepting property of the acid group of the electron accepting compound should be taken into consideration. Specifically, when both the electron accepting properties are large (small), the degree of change in the discolor-photosensitivity is large (small).

The image display medium of the present invention can have a protective layer on the photosensitive layer or the heat generating layer as an outermost layer.

Suitable materials for use in the protective layer include resins having good transparency and high hardness, such as silicone resins, acrylic resins and polyvinyl alcohol. By forming the protective layer, chances of reaction of the compounds included in the photosensitive layer with other materials such as gasses and moisture in the air can be decreased, and mechanical damaging of the photosensitive layer can be prevented (i.e. , the durability of the photosensitive layer can be improved).

Having generally described this invention, a further understanding can be obtained by reference to certain specific examples which are provided herein for purposes of illustration only and are not intended to be limiting. In the descriptions in the following examples, numbers represent weight ratios in parts, unless otherwise specified.

### EXAMPLES

### Example 1

One part of a photochromic compound, 2-[1-(5-methyl-2-p-dimethylaminophenyl-4-oxazolyl)ethylidene]-3-isopropylidene succinic anhydride (hereinafter referred to as PC2), and 9 parts of an electron accepting compound, dococylphosphonic acid having a melting point of 108 °C, were dissolved in tetrahydrofuran. The solution was added to water including a protective colloid and the mixture was agitated at a high speed, to prepare an emulsion.

After sodium carbonate was added to the emulsion to adjust the pH of the mixture to be 9, a urea-formaldehyde prepolymer was added thereto. Then acetic acid was added thereto to adjust the pH of the mixture to be 4. Then the mixture was heated to 60 °C to polymerize the urea-formaldehyde prepolymer at the interfaces between the dispersed particles and the dispersion medium (i.e., to form a film of a urea-formaldehyde resin at the interfaces). Thus, a dispersion in which particles of a microcapsule having a particle diameter of 5 µm are dispersed was prepared.

The thus prepared microcapsule dispersion was coated on a quartz substrate by a blade coating method, followed by drying under a reduced pressure condition, to prepare a film in which particles of the microcapsule are arranged. Then the film was temporarily heated at a temperature of 80 °C by a heater and the absorption spectrum of the film was measured. As a result, the film had a spectrum such that an absorption band is observed in a wavelength range of from 300 nm to a wavelength slightly lower than 400 nm and a maximum absorption is observed at 320 nm.

When ultraviolet light having a wavelength of 366 nm, which is obtained from light emitted by a mercury lamp, irradiated the film, the film was colored magenta and the maximum absorption wavelength of the colored film was 525 nm. When the thus colored film was temporarily heated to 170 °C by a heater, the color of the film changed to reddish magenta. The maximum absorption wavelength of the film having a reddish magenta color was 485 nm. In addition, when the film was temporarily heated to 80 °C by a heater, the color of the film was returned to magenta and the maximum absorption wavelength of the film was 525 nm.

The procedure for preparation of the film was repeated except that the substrate was changed to a white PET (polyethylene terephthalate) having a thickness of 188 µm and a polyvinyl alcohol film having a thickness of 2 µm was formed thereon as a protective layer. The thus prepared films (i.e., the photosensitive layer and the protective layer) was colorless and the image display medium looked white because the substrate is white.

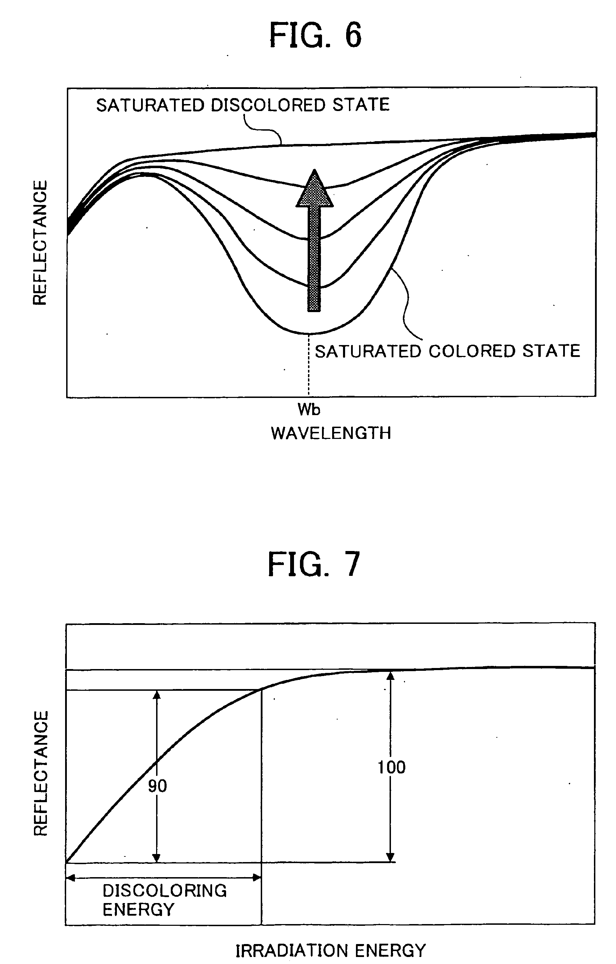

The photosensitive layer of the thus prepared image display medium was temporarily heated to 80 °C by a heater, followed by irradiation of ultraviolet light having a wavelength of 366 nm to color the photosensitive layer. Then a visible light having a spectrum distribution such that the central wavelength is 520 nm, and the half width thereof is 10 nm irradiated the medium at an illuminance of 1 mW/cm². The relationship between the irradiation time (i.e., the irradiation energy) and the reflection spectrum of the medium is illustrated in FIG. 6. When an irradiation energy (i.e., hereinafter referred to as a discoloring energy (1) ) needed for changing the reflectance at a bottom wavelength Wb to 90 % of that of the saturated discolored state was determined, the discoloring energy (1) was 1500 mJ/cm² (see FIG. 3).

Then the image display medium was exposed to ultraviolet light having a wavelength of 366 nm so as to be colored and was temporarily heated to 170 °C by a heater. Further, a visible light having a spectrum distribution such that the central wavelength is 480 nm and the half width thereof is 10 nm irradiated the medium at an illuminance of 1 mW/cm² to determine the discoloring energy (2) of the medium. As a result, the discoloring energy (2) was 20 mJ/cm². Furthermore, the image display medium was exposed to ultraviolet light with a wavelength of 366 nm so as to be colored, followed by temporary heating at 80 °C. Then a visible light having a spectrum distribution such that the central wavelength is 520 nm, and the half width thereof is 10 nm irradiated the medium at an illuminance of 1 mW/cm² to determine again the discoloring energy (1) of the medium. As a result, the discoloring energy (1) was 1500 mJ/cm².

### Example 2

One part of the photochromic compound PC2, and 9 parts of the electron accepting compound, dococylphosphonic acid, were dissolved in tetrahydrofuran. The solution was added to water including a surfactant and the mixture was agitated at a high speed, to prepare an emulsion.

After acetic acid was added to the emulsion to adjust the pH of the mixture to be 4.5, a urea-formaldehyde prepolymer was added thereto. Then the mixture was heated to 70 °C while being agitated at a low speed to polymerize the urea-formaldehyde prepolymer at the interfaces between the dispersed particles and the dispersion medium (i.e., to form a film of a urea-formaldehyde resin at the interfaces). Thus, a dispersion including particles of a microcapsule having a particle diameter of 3 µm was prepared.

The microcapsule was separated from the dispersion and dried under a reduced pressure condition. Then the microcapsule was dispersed in a polycarbonate resin solution and the mixture was coated on a quartz substrate by a blade coating method to prepare a film (i.e. , a photosensitive layer) in which particles of the microcapsule are arranged while the polycarbonate resin serves as a binder resin. Then the film was temporarily heated at a temperature of 80 °C by a heater and the absorption spectrum of the film was measured. As a result, the film had a spectrum such that an absorption band is observed in a wavelength range of from 300 nm to a wavelength slightly lower than 400 nm and a maximum absorption is observed at 320 nm. The film was colorless.

When ultraviolet light having a wavelength of 366 nm, which is obtained from light emitted by a mercury lamp, irradiated the film, the film was colored magenta and the maximum absorption wavelength of the colored film was 525 nm. When the thus colored film was temporarily heated to 170 °C by a heater, the color of the film changed to reddish magenta. The maximum absorption wavelength of the film having a reddish magenta color was 485 nm. In addition, when the film was temporarily heated to 80 °C, the color of the film was returned to magenta and the maximum absorption wavelength of the film was 525 nm.

The procedure for preparation of the film mentioned above was repeated except that the substrate was changed to a white PET (polyethylene terephthalate) having a thickness of 188 µm. Then a polyvinyl alcohol layer having a thickness of 2 µm was formed thereon as a protective layer. The thus prepared films were colorless and the image display medium looked white because the substrate is white.

The discoloring energies (1) and (2) of the thus prepared image display medium were determined in the same way as that in Example 1. As a result, the discoloring energy (1) after heating at 80 °C was 1400 mJ/cm², and the discoloring energy (2) after heating at 170 °C was 20 mJ/cm².

### Example 3

One part of the photochromic compound PC2, and 9 parts of the electron accepting compound, dococylphosphonic acid, were dissolved in tetrahydrofuran. The solution was added to a mixture of an aqueous solution of gelatin and an aqueous solution of gum arabic. The mixture was heated to 50 °C and an aqueous solution of sodium hydroxide was added thereto to adjust the pH thereof to be 9. Then the mixture was agitated at a high speed to prepare an emulsion.

Then the pH of the emulsion was adjusted so as to be 4, to form a thick solution of gelatin and gum arabic around the surface of the dispersed solution particles of the PC2 and dococylphosphonic acid. Further, the dispersion was cooled such that gelatin and gum arabic gelate. Then an aqueous solution of glutaric aldehyde was added thereto to crosslink the gelatin and gum arabic film. Thus, a dispersion including particles of a microcapsule having a particle diameter of 5 µm was prepared.

The microcapsule was separated from the dispersion and dried under a reduced pressure condition. Then the microcapsule was dispersed in a polycarbonate resin solution and the mixture was coated on a quartz substrate by a blade coating method to prepare a film in which particles of the microcapsule are arranged while the polycarbonate resin serves as a binder resin. Then the film was temporarily heated at a temperature of 80 °C by a heater and the absorption spectrum of the film was measured. As a result, the film had a spectrum such that an absorption band is observed in a wavelength range of from 300 nm to a wavelength slightly lower than 400 nm and a maximum absorption is observed at 320 nm. The film was colorless.

When ultraviolet light having a wavelength of 366 nm, which is obtained from light emitted by a mercury lamp, irradiated the film, the film was colored magenta and the maximum absorption wavelength of the colored film was 525 nm. When the thus colored film was temporarily heated to 170 °C by a heater, the color of the film changed to reddish magenta. The maximum absorption wavelength of the film having a reddish magenta color was 485 nm. In addition, when the film was temporarily heated to 80 °C by a heater, the color of the film was returned to magenta and the maximum absorption wavelength of the film was 525 nm.

The procedure for preparation of the film mentioned above was repeated except that the substrate was changed to a white PET (polyethylene terephthalate) having a thickness of 188 µm. Then a polyvinyl alcohol layer having a thickness of 2 µm was formed thereon as a protective layer. The thus prepared films were colorless and the image display medium looked white because the substrate is white.

The discoloring energies (1) and (2) of the thus prepared image display medium were determined in the same way as that in Example 1. As a result, the discoloring energy (1) after heating at 80 °C was 1500 mJ/cm², and the discoloring energy (2) after heating at 170 °C was 20 mJ/cm².

### Example 4

One part of the photochromic compound PC2, 9 parts of the electron accepting compound, dococylphosphonic acid, and 1 part of a metal complex dye (PA-1006 from Mitsui Chemicals, Inc., hereinafter referred to as D1) serving as an infrared absorbing dye, were dissolved in tetrahydrofuran. The solution was added to water including a protective colloid and the mixture was agitated at a high speed, to prepare an emulsion.

After sodium carbonate was added to the emulsion to adjust the pH of the mixture to be 9, a urea-formaldehyde prepolymer was added thereto. Then acetic acid was added thereto to adjust the pH of the mixture to be 4. Then the mixture was heated to 60 °C to polymerize the urea / formaldehyde prepolymer at the interfaces between the dispersed particles and the dispersion medium (i.e., to form a film of a urea-formaldehyde resin at the interfaces). Thus, a dispersion including particles of a microcapsule having a particle diameter of 5 µm was prepared.

The microcapsule was separated from the dispersion and dried under a reduced pressure condition. Then the microcapsule was dispersed in a polycarbonate resin solution and the mixture was coated on a quartz substrate by a blade coating method to prepare a film in which particles of the microcapsule are arranged while the polycarbonate resin serves as a binder resin. Then the film was exposed to infrared light to be temporarily heated to a temperature of 80 °C and the absorption spectrum of the film was measured. As a result, the film had a spectrum such that an absorption band is observed in a wavelength range of from 300 nm to a wavelength slightly lower than 400 nm and a maximum absorption is observed at 320 nm. The film was colorless.

When ultraviolet light having a wavelength of 366 nm, which is obtained from light emitted by a mercury lamp, irradiated the film, the film was colored magenta and the maximum absorption wavelength of the colored film was 525 nm. When the thus colored film was exposed to infrared light to be temporarily heated to 170 °C, the color of the film changed to reddish magenta. The maximum absorption wavelength of the film having a reddish magenta color was 485 nm. In addition, when the film was temporarily heated to 80 °C, the color of the film was returned to magenta and the maximum absorption wavelength of the film was 525 nm.

The procedure for preparation of the film mentioned above was repeated except that the substrate was changed to a white PET (polyethylene terephthalate) having a thickness of 188 µm. Then a polyvinyl alcohol layer having a thickness of 2 µm was formed thereon as a protective layer. The thus prepared films were colorless and the image display medium looked white because the substrate is white.

The discoloring energies (1) and (2) of the thus prepared image display medium were determined in the same way as that in Example 1. As a result, the discoloring energy (1) after heating at 80 °C was 1500 mJ/cm², and the discoloring energy (2) after heating at 170 °C was 20 mJ/cm².

### Example 5

The procedure for preparation of the microcapsule in Example 1 was repeated. Then a polycarbonate solution was mixed with D1 having the same weight of the polycarbonate included in the solution and the microcapsule prepared above to prepare a photosensitive layer coating liquid. The coating liquid was coated on a quartz substrate to prepare a microcapsule film. Then the film was exposed to infrared light to be temporarily heated to a temperature of 80 °C and the absorption spectrum of the film was measured. As a result, the film had a spectrum such that an absorption band is observed in a wavelength range of from 300 nm to a wavelength slightly lower than 400 nm and a maximum absorption is observed at 320 nm. The film was colorless.

When ultraviolet light having a wavelength of 366 nm, which is obtained from light emitted by a mercury lamp, irradiated the film, the film was colored magenta and the maximum absorption wavelength of the colored film was 525 nm. When the thus colored film was exposed to infrared light to be temporarily heated to 170 °C, the color of the film changed to reddish magenta. The maximum absorption wavelength of the film having a reddish magenta color was 485 nm. In addition, when the film was temporarily heated to 80 °C, the color of the film was returned to magenta and the maximum absorption wavelength of the film was 525 nm.

The procedure for preparation of the film mentioned above was repeated except that the substrate was changed to a white PET (polyethylene terephthalate) having a thickness of 188 µm. Then a polyvinyl alcohol layer having a thickness of 2 µm was formed thereon as a protective layer. The thus prepared films were colorless and the image display medium looked white because the substrate is white.

The discoloring energies (1) and (2) of the thus prepared image display medium were determined in the same way as that in Example 1. As a result, the discoloring energy (1) after heating at 80 °C was 1500 mJ/cm², and the discoloring energy (2) after heating at 170 °C was 20 mJ/cm².

### Example 6

The procedure for preparation of the image display medium in Example 2 was repeated except that a heat generating layer having a thickness of 5 µm was formed between the photosensitive layer and the protective layer by coating a coating liquid which had been prepared by dissolving 1 part of D1 and 6 parts of a polycarbonate resin in 50 parts of tetrahydrofuran.

After the image display medium was subjected to the heat treatment (i.e., infrared light irradiation) performed in Example 4, the discoloring energies (1) and (2) of the image display medium were determined. As a result, the discoloring energy (1) after heating at 80 °C was 1400 mJ/cm², and the discoloring energy (2) after heating at 170 °C was 20 mJ/cm².

### Example 7

The procedure for preparation of the microcapsule film in Example 5 was repeated except that the photochromic compound PC2 was replaced with 2-[1-(5-methyl-2-p-dimethylaminophenyl-4-oxazolyl)-2-trifluoromethylethylidene]-3-isopropylidene succinic anhydride (hereinafter referred to as PC1) or 2-[1-(2,5-dimethyl-1-p-dimethylaminophenyl-3-pyrrolyl)ethylidene]-3-isopropylidene succinic anhydride (hereinafter referred to as PC3). Thus, two kinds of microcapsule films were prepared.

Then the films were exposed to infrared light to be temporarily heated to a temperature of 80 °C and the absorption spectra of the films were measured. As a result, the film including PC1 had a spectrum such that an absorption band is observed in a wavelength range of from 300 nm to a wavelength slightly lower than 400 nm and a maximum absorption is observed at 337 nm, and the film including PC3 had a spectrum such that an absorption band is observed in a wavelength range of from 300 nm to a wavelength slightly lower than 400 nm and a maximum absorption is observed at 360 nm. These films were colorless.

When ultraviolet light having a wavelength of 366 nm, which is obtained from light emitted by a mercury lamp, irradiated the films, the film including PC1 was colored yellow and the maximum absorption wavelength of the colored film was 450 nm. The film including PC3 was colored cyan and the maximum absorption wavelength of the colored film was 660 nm. When the thus colored films were exposed to infrared light to be temporarily heated to 170 °C, the colors of the films changed such that the maximum absorption wavelengths of the films are 420 nm and 620 nm, respectively. In addition, when the films were temporarily heated to 80 °C by being exposed to infrared light, the colors of the films were returned to yellow and cyan, respectively, and the maximum absorption wavelengths of the films were 450 nm and 660 nm, respectively.

The thus prepared microcapsules (1) and (3) including PC1 and PC3, respectively, and the microcapsule (2) including PC2 prepared in the same way as that in Example 5 were dried under a reduced pressure condition.

One part of each of the microcapsules (1), (2) and (3) was mixed with 1 part of D1 and a polycarbonate solution which had been prepared by dissolving 6 parts of a polycarbonate resin in 40 parts of tetrahydrofuran to prepare a coating liquid. The coating liquid was coated on a white PET film having a thickness of 188 µm to prepare a photosensitive layer having a thickness of 8 µm. Then a polyvinyl alcohol film having a thickness of 2 µm was formed thereon as a protective layer. The thus prepared photosensitive layer and the protective layer were colorless and the image displaying medium looked white because the substrate thereof is white.

After infrared light irradiated the image displaying medium to temporarily heated the medium to 80 °C, followed by irradiation of ultraviolet light having a wavelength of 366 nm, the medium was colored black because all the microcapsules (1), (2) and (3) colored. When white light irradiated the black-colored medium, the color of the image display medium returned to white (i.e., the color of the photosensitive layer returned to colorless).

Then ultraviolet light of 366 nm irradiated the image display medium to color the photosensitive layer. Further, a visible light having a spectrum distribution such that the central wavelength is 450 nm and the half width thereof is 10 nm irradiated a portion of the photosensitive layer of the image display medium. As a result, the portion of the image display medium had a blue color because the microcapsule (1) was selectively discolored. In addition, another visible light having a spectrum distribution such that the central wavelength is 520 nm and the half width thereof is 10 nm irradiated another portion of the photosensitive layer of the image display medium. As a result, the portion of the image display medium had a green color because the microcapsule (2) was selectively discolored. Further, another visible light having a spectrum distribution such that the central wavelength is 660 nm and the half width thereof is 10 nm irradiated another portion of the photosensitive layer of the image display medium. As a result, the portion of the image display medium had a red color because the microcapsule (3) was selectively discolored.

The discoloring energy (1) of each of the microcapsules (1), (2) and (3), which was determined in the same way as that in Example 1, was 670 mJ/cm², 1160 mJ/cm² and 880 mJ/cm².

Then ultraviolet light of 366 nm irradiated the photosensitive layer of the image display medium to color the photosensitive layer, followed by irradiation of infrared light to temporarily heat the photosensitive layer to 170 °C. Further, the discoloring energy (2) of each of the microcapsules (1), (2) and (3) was determined in the same way as that mentioned above using visible lights having central wavelengths of 420 nm, 480 nm and 620 nm, respectively. As a result, the discoloring energy (2) of each of the microcapsules (1), (2) and (3) was 20 mJ/cm², 33 mJ/cm² and 26 mJ/cm².

Furthermore, ultraviolet light of 366 nm irradiated the photosensitive layer to color the photosensitive layer, followed by irradiation of infrared light to temporarily heat again the photosensitive layer to 80 °C. Then the discoloring energy (1) of the microcapsules (1), (2) and (3) was determined again. As a result, the discoloring energy (1) of the microcapsules (1), (2) and (3) was 670 mJ/cm², 1160 mJ/cm² and 880 mJ/cm².

Thus, it was confirmed that in the photosensitive layer including three kinds of microcapsules, the discoloring energies of the microcapsules can be reversibly changed largely by infrared light irradiation.

### Example 8

One part of the photochromic compound PC1, 1 part of the photochromic compound PC2, 1 part of the photochromic compound PC3, and 27 parts of the electron accepting compound, dococylphosphonic acid, were dissolved in tetrahydrofuran. The solution was added to water including a protective colloid and the mixture was agitated at a high speed, to prepare an emulsion.

After sodium carbonate was added to the emulsion to adjust the pH of the mixture to be 9, a urea-formaldehyde prepolymer was added thereto. Then acetic acid was added thereto to adjust the pH of the mixture to be 4. Then the mixture was heated to 60 °C to polymerize the urea / formaldehyde prepolymer at the interfaces between the dispersed particles and the dispersion medium (i.e., a film of a urea-formaldehyde resin be formed at the interfaces). Thus, a microcapsule having a particle diameter of 5 µm was prepared.

The microcapsule was separated from the dispersion and dried under a reduced pressure condition. Then 3 parts of the microcapsule and 1 part of the infrared absorbing dye D1 were dispersed in a polycarbonate resin solution which had been prepared by dissolving 6 parts of a polycarbonate resin in 40 parts of tetrahydrofuran and the mixture was coated on a white PET having a thickness of 188 µm by a blade coating method to prepare a film having a thickness of 8 µm in which particles of the microcapsule are arranged while the polycarbonate resin serves as a binder resin. Further, a polyvinyl alcohol film having a thickness of 2 µm was formed thereon. The thus prepared photosensitive layer and the protective layer were colorless, and the image display medium looked white because the substrate is white.

After infrared light irradiated the image displaying medium to temporarily heated the medium to 80 °C, followed by irradiation of ultraviolet light with a wavelength of 366 nm, the medium was colored black because all the photochromic compounds (PC1), (PC2) and (PC3) colored. When white light irradiated the black-colored medium, the color of the image display medium returned to white (i.e., the color of the photosensitive layer returned to colorless).

Then ultraviolet light of 366 nm irradiated the image display medium to color the photosensitive layer. Further, a visible light having a spectrum distribution such that the central wavelength is 450 nm and the half width thereof is 10 nm irradiated a portion of the photosensitive layer of the image display medium. As a result, the portion of the image display medium had a blue color because the photochromic compound (PC1) was selectively discolored. In addition, another visible light having a spectrum distribution such that the central wavelength is 520 nm and the half width thereof is 10 nm irradiated another portion of the photosensitive layer of the image display medium. As a result, the portion of the image display medium had a green color because the photochromic compound (PC2) was selectively discolored. Further, another visible light having a spectrum distribution such that the central wavelength is 660 nm and the half width thereof is 10 nm irradiated another portion of the photosensitive layer of the image display medium. As a result, the portion of the image display medium had a red color because the photochromic compound (PC3) was selectively discolored.

The discoloring energy (1) of each of the photochromic compounds (PC1), (PC2) and (PC3), which was determined in the same way as that in Example 1 using the above-mentioned three visible lights, was 670 mJ/cm², 1160 mJ/cm² and 880 mJ/cm².

Then ultraviolet light of 366 nm irradiated the photosensitive layer of the image display medium to color the photosensitive layer, followed by irradiation of infrared light to temporarily heat the photosensitive layer to 170°C. Further, the discoloring energy (2) of each of the photochromic compounds (PC1), (PC2) and (PC3) was determined in the same way as that mentioned above using visible lights of 420 nm, 480 nm and 620 nm. As a result, the discoloring energy (2) of each of the photochromic compounds (PC1), (PC2) and (PC3) was 20 mJ/cm², 33 mJ/cm² and 26 mJ/cm².

Furthermore, ultraviolet light of 366 nm irradiated the photosensitive layer to color the photosensitive layer, followed by irradiation of infrared light to temporarily heat again the photosensitive layer to 80 °C. Then the discoloring energy (1) of the photochromic compounds (PC1) , (PC2) and (PC3) was determined again. As a result, the discoloring energy (1) of the photochromic compounds (PC1), (PC2) and (PC3) was 670 mJ/cm², 1160 mJ/cm² and 880 mJ/cm².

Thus, it was confirmed that in the photosensitive layer including a microcapsule including three kinds of photochromic compounds therein, the discoloring energies of the photochromic compounds can be reversibly changed largely by irradiating infrared light.

### Example 9

One part of the photochromic compound PC2, 9 parts of dococylphosphonic acid, and 1 part of the infrared light absorbing dye D1 were dissolved in tetrahydrofuran. The solution was added to water including a protective colloid and the mixture was agitated at a high speed, to prepare an emulsion.

After sodium carbonate was added to the emulsion to adjust the pH of the mixture to be 9, a urea / formaldehyde prepolymer was added thereto. Then acetic acid was added thereto to adjust the pH of the mixture to be 4. Then the mixture was heated to 60 °C to polymerize the urea-formaldehyde prepolymer at the interfaces between the dispersed particles and the dispersion medium (i.e., to form a film of a urea-formaldehyde resin at the interfaces). Thus, a first microcapsule having a particle diameter of 5 µm was prepared.

The procedure for preparation of the first microcapsule mentioned above was repeated except that the photochromic compound PC2 was replaced with the photochromic compound PC1, and dococylphosphonic acid was replaced with p-(octadecylthio)phenol. Thus a second microcapsule was prepared.

The procedure for preparation of the first microcapsule mentioned above was repeated except that the photochromic compound PC2 was replaced with the photochromic compound PC3, and dococylphosphonic acid was replaced with 2-octadecylglutaric acid. Thus a third microcapsule was prepared.

The thus prepared three microcapsules were separated from the respective dispersions, and then dried under a reduced pressure condition. The three microcapsules each having the same weight were mixed and the mixture was dispersed in a polycarbonate solution to prepare a photosensitive layer coating liquid. The coating liquid was coated on a white PET having a thickness of 188 µm to form a photosensitive layer. In addition, a polyvinyl alcohol film having a thickness of 2 µm was formed on the photosensitive layer as a protective layer. The thus prepared photosensitive layer and the protective layer were colorless and the image display medium looked white because the substrate is white.

After infrared light irradiated the image displaying medium to temporarily heated the medium to 80 °C, followed by irradiation of ultraviolet light with a wavelength of 366 nm, the medium was colored black because all the photochromic compounds (PC1), (PC2) and (PC3) colored. When white light irradiated the black-colored medium, the color of the image display medium was returned to white (i.e., the color of the photosensitive layer was returned to colorless).

Then ultraviolet light of 366 nm irradiated the image display medium to color the photosensitive layer. Further, a visible light having a spectrum distribution such that the central wavelength is 450 nm and the half width thereof is 10 nm irradiated a portion of the photosensitive layer of the image display medium. As a result, the portion of the image display medium had a blue color because the photochromic compound (PC1) was selectively discolored. In addition, another visible light having a spectrum distribution such that the central wavelength is 520 nm and the half width thereof is 10 nm irradiated another portion of the photosensitive layer of the image display medium. As a result, the portion of the image display medium had a green color because the photochromic compound (PC2) was selectively discolored. Further, another visible light having a spectrum distribution such that the central wavelength is 660 nm and the half width thereof is 10 nm irradiated another portion of the photosensitive layer of the image display medium. As a result, the portion of the image display medium had a red color because the photochromic compound (PC3) was selectively discolored.

The discoloring energy (1) of each of the photochromic compounds (PC1), (PC2) and (PC3), which was determined in the same way as that in Example 1 using the three visible lights mentioned above, was 670 mJ/cm², 1160 mJ/cm² and 880 mJ/cm².

Then ultraviolet light of 366 nm irradiated the photosensitive layer of the image display medium to color the photosensitive layer, followed by irradiation of infrared light to temporarily heat the photosensitive layer to 170 °C. Further, the discoloring energy (2) of each of the photochromic compounds (PC1), (PC2) and (PC3) was determined in the same way as that mentioned above using visible lights of 420 nm, 480 nm and 620 nm. As a result, the discoloring energy (2) of each of the photochromic compounds (PC1), (PC2) and (PC3) was 30 mJ/cm², 33 mJ/cm² and 32 mJ/cm².

Furthermore, ultraviolet light of 366 nm irradiated the photosensitive layer to color the photosensitive layer, followed by irradiation of infrared light to temporarily heat again the photosensitive layer to 80 °C. Then the discoloring energy (1) of the photochromic compounds (PC1) , (PC2) and (PC3) was determined again. As a result, the discoloring energy (1) of the photochromic compounds (PC1), (PC2) and (PC3) was 670 mJ/cm², 1160 mJ/cm² and 880 mJ/cm².

Thus, it was confirmed that by combining three kinds of photochromic compounds with respective proper electron accepting compounds, the discoloring energies of the systems can be nearly equalized to each other.

### Effects of the Invention

(1) By microencapsulating a photochromic compound and an electron accepting compound, it becomes possible to prevent materials other than the compounds from influencing on the interaction of the compounds, i.e., it becomes possible to securely control the interaction therebetween. Therefore, it becomes possible to reversibly change the discoloring sensitivity of the resultant image display medium.
(2) When the photosensitive layer includes the microcapsule and a binder resin, the adhesion of the microcapsule particles to each other and to the substrate can be improved, and the resultant photosensitive layer and image display medium have good physical strength.
(3) By including an infrared absorbing dye in the microcapsule, the discoloring sensitivity can be changed only by light irradiation. In addition, since the infrared absorbing dye is included in the microcapsule together with the photochromic compound and the electron accepting compound, the compounds can be effectively headed by the heat generated by the infrared absorbing dye.
(4) When the photosensitive layer includes the microcapsule, a binder and an infrared absorbing dye, the discoloring sensitivity can be changed only by light irradiation. Since the infrared absorbing dye is included in the photosensitive layer, the flexibility in forming the microcapsule can be improved.
(5) By forming a heat generating layer on the photosensitive layer or between the substrate and the photosensitive layer, the discoloring sensitivity can be changed only by light irradiation while the flexibility in forming the microcapsule and the photosensitive layer can be improved.
(6) By using two or more kinds of photochromic compounds having different maximum absorption wavelengths, it becomes possible to display a multi-color image while the discoloring sensitivity of the image display medium can be controlled.
(7) By using a photochromic compound (A) having a maximum absorption wavelength not less than 400 nm and less than 500 nm in the colored state, a photochromic compound (B) having a maximum absorption wavelength not less than 500 nm and less than 600 nm in the colored state, and a photochromic compound (C) having a maximum absorption wavelength not less than 600 nm and less than 700 nm in the colored state, it becomes possible to display color images with a variety of color tones while the discoloring sensitivity of the image display medium can be reversibly changed. Therefore, it becomes possible to shorten the image forming time and to impart good color retentivity to the image displaying medium.
(8) When the photosensitive layer includes the three different microcapsules including the photochromic compounds (A), (B) and (C), respectively, the degree of the discoloring sensitivity can be controlled for each of the microcapsules.
(9) By forming a protective layer as an outermost layer of the image display medium, it becomes possible to impart good physical and chemical durability to the image display medium.
(10) According to the image displaying method of the present invention, the discoloring sensitivity can be reversibly changed and it becomes possible to shorten the image forming time and to impart good color retentivity to the image displaying medium.
(11) By irradiating a heat generation layer formed on the image display medium with infrared light, the discoloring sensitivity can be changed only by light irradiation. Therefore, it becomes possible to shorten the image forming time and to impart good color retentivity to the image displaying medium.
(12) By performing, on the image displaying medium mentioned above in numbered paragraphs (6) to (8), operations of irradiating the medium with ultraviolet light, heating the medium to a temperature not lower than the melting point of the electron accepting compound, irradiating the colored medium with visible lights corresponding to the maximum absorption wavelengths of the colored photochromic compounds, and heating the medium to a temperature not higher than the melting point of the electron accepting compound, it becomes possible to display color images while the discoloring sensitivity can be reversibly changed. Therefore, it becomes possible to shorten the image forming time and to impart good color retentivity to the image displaying medium.
(13) By performing the heating operation using infrared light, color images can be displayed while discoloring can be performed only by light irradiation. Therefore, it becomes possible to shorten the image forming time and to impart good color retentivity to the image displaying medium.

This document claims priority and contains subj ect matter related to Japanese Patent Application No. 2003-426253, filed on December 24, 2003.

## Claims

1. An image display medium comprising:
a substrate; and
a photosensitive layer which is located overlying the substrate and comprises a microcapsule containing at least one photochromic compound and at least one electron accepting compound,
wherein the at least one electron accepting compound includes a Lewis acid compound having not less than 12 carbon atoms except for carbons included in a Lewis acid group thereof.

2. The image display medium according to Claim 1, wherein the at least one photochromic compound comprises a fulgide compound.

3. The image display medium according to Claim 1 or 2, wherein the photosensitive layer further comprises a binder.

4. The image display medium according to any one of Claims 1 to 3, wherein the photosensitive layer further comprises an infrared absorbing dye in the photosensitive layer and/or in the microcapsule.

5. The image display medium according to any one of Claims 1 to 3, further comprising a heat generating layer which is located overlying the photosensitive layer or between the substrate and the photosensitive layer and which comprises an infrared absorbing dye.

6. The image display medium according to any one of Claims 1 to 5, wherein the at least one photochromic compound comprises two or more kinds of photochromic compounds having different maximum absorption wavelengths when being colored.

7. The image display medium according to Claim 6, wherein the at least one photochromic compound comprises a photochromic compound (A) having a maximum absorption wavelength not less than 400 nm and less than 500 nm when being colored, a photochromic compound (B) having a maximum absorption wavelength not less than 500 nm and less than 600 nm when being colored, and a photochromic compound (C) having a maximum absorption wavelength not less than 600 nm and less than 700 nm when being colored.

8. The image display medium according to Claim 7, wherein the microcapsule comprises a first microcapsule containing the photochromic compound (A) as the photochromic compound, a second microcapsule containing the photochromic compound (B) as the photochromic compound, and a third microcapsule containing the photochromic compound (C) as the photochromic compound.

9. The image display medium according to any one of Claims 1 to 8, further comprising a protective layer which is located overlying the photosensitive layer or the heat generating layer as an outermost layer of the image display medium.

10. An image forming method comprising:
irradiating an image display medium according to any one of Claims 1 to 9 with ultraviolet light to color the at least one photochromic compound;
first heating the image display medium to a temperature not lower than a melting point of the at least one electron accepting compound;
imagewise irradiating the image display medium with visible light corresponding to the maximum absorption wavelength of the colored at least one photochromic compound to imagewise discolor the colored image display medium; and
second heating the image display medium to a temperature lower than the melting point of the at least one electron accepting compound.

11. The method according to Claim 10, wherein the first and second heating are performed by irradiating the photosensitive layer and/or the heat generating layer of the image display medium according to any one of Claims 4 to 9 with infrared light.

## Patentansprüche

1. Bildanzeigemedium, umfassend:
ein Substrat; und
eine lichtempfindliche Schicht, die über dem Substrat angeordnet ist und eine Mikrokapsel, die mindestens eine photochrome Verbindung und mindestens eine Elektronenakzeptorverbindung enthält, umfasst,
worin die mindestens eine Elektronenakzeptorverbindung eine Lewis-Säure-Verbindung mit nicht weniger als 12 Kohlenstoffatomen außer den Kohlenstoffatomen in der Lewis-Säure-Gruppe davon beinhaltet.

2. Bildanzeigemedium nach Anspruch 1, worin die mindestens eine photochrome Verbindung eine Fulgidverbindung umfasst.

3. Bildanzeigemedium nach Anspruch 1 oder 2, worin die lichtempfindliche Schicht ferner ein Bindemittel umfasst.

4. Bildanzeigemedium nach irgendeinem der Ansprüche 1 bis 3, worin die lichtempfindliche Schicht ferner einen Infrarot-absorbierenden Farbstoff in der lichtempfindlichen Schicht und/oder in der Mikrokapsel umfasst.

5. Bildanzeigemedium nach irgendeinem der Ansprüche 1 bis 3, ferner umfassend eine Wärmeerzeugungsschicht, die über der lichtempfindlichen Schicht oder zwischen dem Substrat und der lichtempfindlichen Schicht angeordnet ist und die einen Infrarot-absorbierenden Farbstoff umfasst.

6. Bildanzeigemedium nach irgendeinem der Ansprüchen 1 bis 5, worin die mindestens eine photochrome Verbindung zwei oder mehr Arten von photochromen Verbindungen umfasst, die unterschiedliche maximale Absorptionswellenlängen aufweisen, wenn sie gefärbt sind.

7. Bildanzeigemedium nach Anspruch 6, worin die mindestens eine photochrome Verbindung eine photochrome Verbindung (A) mit einer maximalen Absorptionswellenlänge von nicht weniger als 400 nm und weniger als 500 nm, wenn sie gefärbt ist, eine photochrome Verbindung (B) mit einer maximalen Absorptionswellenlänge von nicht weniger als 500 nm und weniger als 600 nm, wenn sie gefärbt ist, und eine photochrome Verbindung (C) mit einer maximalen Absorptionswellenlänge von nicht weniger als 600 nm und weniger als 700 nm, wenn sie gefärbt ist, umfasst.

8. Bildanzeigemedium nach Anspruch 7, worin die Mikrokapsel eine erste Mikrokapsel enthaltend die photochrome Verbindung (A) als photochrome Verbindung, eine zweite Mikrokapsel enthaltend die photochrome Verbindung (B) als photochrome Verbindung und eine dritte Mikrokapsel enthaltend die photochrome Verbindung (C) als photochrome Verbindung umfasst.

9. Bildanzeigemedium nach irgendeinem der Ansprüche 1 bis 8, ferner umfassend eine Schutzschicht, die über der lichtempfindlichen Schicht oder der Wärmeerzeugungsschicht als äußerste Schicht des Bildanzeigemediums angeordnet ist.

10. Bilderzeugungsverfahren, umfassend:
das Bestrahlen eines Bildanzeigemediums nach irgendeinem der Ansprüche 1 bis 9 mit Ultraviolettlicht, um die mindestens eine photochrome Verbindung zu färben;
das erste Erwärmen des Bildanzeigemediums auf eine Temperatur, die nicht niedriger ist als der Schmelzpunkt der mindestens einen Elektronenakzeptorverbindung;
das bildmäßige Bestrahlen des Bildanzeigemediums mit sichtbarem Licht, das der maximalen Absorptionswellenlänge der mindestens einen farbigen photochromen Verbindung entspricht, um das gefärbte Bildanzeigemedium bildmäßig zu entfärben; und
das zweite Erwärmen des Bildanzeigemediums auf eine Temperatur, die niedriger ist als der Schmelzpunkt der mindestens einen Elektronenakzeptorverbindung.

11. Verfahren nach Anspruch 10, worin das erste und zweite Erwärmen durch Bestrahlen der lichtempfindlichen Schicht und/oder der Wärmeerzeugungsschicht des Bildanzeigemediums nach irgendeinem der Ansprüche 4 bis 9 mit Infrarotlicht durchgeführt wird.

## Revendications

1. Support d'affichage d'image comprenant :
un substrat ; et
une couche photosensible qui est située en recouvrement du substrat et qui comprend une microcapsule contenant au moins un composé photochrome et au moins un composé accepteur d'électrons ;
dans lequel l'au moins un composé accepteur d'électrons inclut un composé acide de Lewis n'ayant pas moins de 12 atomes de carbone non compris les carbones inclus dans son groupe acide de Lewis.

2. Support d'affichage d'image selon la revendication 1, dans lequel l'au moins un composé photochrome comprend un composé fulgide.

3. Support d'affichage d'image selon la revendication 1 ou 2, dans lequel la couche photosensible comprend en outre un liant.

4. Support d'affichage d'image selon l'une quelconque des revendications 1 à 3, dans lequel la couche photosensible comprend en outre un colorant absorbant l'infrarouge dans la couche photosensible et/ou dans la microcapsule.

5. Support d'affichage d'image selon l'une quelconque des revendications 1 à 3, comprenant en outre une couche génératrice de chaleur qui est située en recouvrement de la couche photosensible ou entre le substrat et la couche photosensible et qui comprend un colorant absorbant l'infrarouge.

6. Support d'affichage d'image selon l'une quelconque des revendications 1 à 5, dans lequel l'au moins un composé photochrome comprend au moins deux sortes de composés photochromes ayant des longueurs d'onde d'absorption maximale différentes lorsqu'ils sont colorés.

7. Support d'affichage d'image selon la revendication 6, dans lequel l'au moins un composé photochrome comprend un composé photochrome (A) ayant une longueur d'onde d'absorption maximale pas inférieure à 400 nm et inférieure à 500 nm lorsqu'il est coloré, un composé photochrome (B) ayant une longueur d'onde d'absorption maximale pas inférieure à 500 nm et inférieure à 600 nm lorsqu'il est coloré, et un composé photochrome (C) ayant une longueur d'onde d'absorption maximale pas inférieure à 600 nm et inférieure à 700 nm lorsqu'il est coloré.

8. Support d'affichage d'image selon la revendication 7, dans lequel la microcapsule comprend une première microcapsule contenant, comme composé photochrome, le composé photochrome (A), une deuxième microcapsule contenant, comme composé photochrome, le composé photochrome (B), et une troisième microcapsule contenant, comme composé photochrome, le composé photochrome (C).

9. Support d'affichage d'image selon l'une quelconque des revendications 1 à 8, comprenant en outre, en tant que couche le plus à l'extérieur du support d'affichage d'image, une couche de protection qui est située en recouvrement de la couche photosensible ou de la couche génératrice de chaleur.

10. Procédé de formation d'image comprenant :
l'éclairage d'un support d'affichage d'image selon l'une quelconque des revendications 1 à 9 avec de la lumière ultraviolette pour colorer l'au moins un composé photochrome ;
un premier chauffage du support d'affichage d'image jusqu'à une température pas inférieure au point de fusion de l'au moins un composé accepteur d'électrons ;
l'éclairage au niveau de l'image du support d'affichage d'image avec de la lumière visible correspondant à la longueur d'onde d'absorption maximale de l'au moins un composé photochrome coloré pour décolorer au niveau de l'image le support d'affichage d'image coloré ; et
un second chauffage du support d'affichage d'image jusqu'à une température inférieure au point de fusion de l'au moins un composé accepteur d'électrons.

11. Procédé selon la revendication de 10, dans lequel les premier et second chauffages sont effectués par éclairage, avec de la lumière infrarouge, de la couche photosensible et/ou de la couche génératrice de chaleur du support d'affichage d'image selon l'une quelconque des revendications 4 à 9.
